# EUROPEAN PATENT SPECIFICATION

(11) **EP 2 772 642 B1**
(45) Date of publication and mention of the grant of the patent: **03.08.2016**
(21) Application number: 13196863.8
(22) Date of filing: 12.12.2013
(51) Int. Cl.: F02N 19/00, F02N 11/08, G01R 31/36, G01R 31/00

(54) **Engine control device with means for determining a status of a battery**
Motorsteuerungsvorrichtung
Dispositif de commande de moteur

(30) Priority: 28.02.2013 JP 2013039507
(43) Date of publication of application: 03.09.2014
(73) Proprietor: Honda Motor Co., Ltd., Tokyo 107-8556 (JP)
(72) Inventor: Osawa, Toshifumi, Saitama, 351-0193 (JP); Takeshige, Tetsuo, Saitama, 351-0193 (JP); Nishi, Atsushi, Saitama, 351-0193 (JP); Takayama, Keishi, Saitama, 351-0193 (JP)
(74) Representative: Weickmann & Weickmann PartmbB

(56) References cited:
- WO-A1-2011/009511
- JP-A- S58 140 445
- JP-A- 2004 028 011
- US-A1- 2009 115 419

## Description

### Technical Field

The present invention relates to an engine control device which drives a crankshaft of an engine in a normal rotation direction and in a reverse rotation direction based on control of a motor.

### Background Art

Typically, when an engine is to be started, torque for driving a crankshaft in a normal rotation direction is transmitted from a motor to the crankshaft to trigger initial rotation of the crankshaft, and then owing to this initial rotation, the engine transitions to self-rotation of the crankshaft using fuel combustion. In this rotation by the motor, it is known to perform swing-back control which drives the crankshaft in a reverse rotation direction before driving it in the normal rotation direction to increase a run-up length for a piston inside the engine to reach the compression top dead center so that the piston can reach beyond the compression top dead center by utilizing inertia force (see JP-A-2010-223135).

In an engine start control device disclosed in JP-A-2010-223135, the crankshaft is driven in the reverse rotation direction when an engine is started by a starter switch and when the engine is stopped by idle-stop control. Particularly when the crankshaft is driven in the reverse rotation direction during the idle-stop control, the piston is prevented from being returned in the normal rotation direction from the compression top dead center by a control which reduces torque applied to the crankshaft (to reduce the speed of reverse rotation).

An engine control device according to the preamble of claim 1 is known from JP 2004-028011 A.

### Summary of the Invention

### Problems to be Solved by the Invention

Incidentally, when a vehicle configured to perform idle-stop control is to restart after being automatically stopped by the idle-stop control, sufficient power needs to be supplied from a battery to the motor to drive the crankshaft in the normal rotation direction. If the battery is running low, troubles such as stop of the drive of the engine during execution of the idle-stop control may occur. For this reason, when a vehicle configured to perform the idle-stop control starts (i.e., when the engine is started), the vehicle should desirably know the status of the battery in advance and determine whether or not to perform the idle-stop control.

The present invention has been made in consideration of the above demand, and has an objective of providing an engine control device capable of precisely controlling reverse rotation drive of a crankshaft when starting an engine, and of favorably detecting the status of a battery by effectively utilizing this reverse rotation drive.

### Means for Solving the Problems

An engine control device (10) according to the present invention has the following aspects.

A first aspect: An engine control device (10) comprises a controller (36) configured to perform, when starting an engine (E), swing-back control in which a motor (70) driven based on a supply current from a battery (96) drives a crankshaft (48) in a reverse rotation direction, and after the drive in the reverse rotation direction, drives the crankshaft (48) in a normal rotation direction. In the engine control device (10), the controller (36) has: a supply controller (128) configured to set a current value or a duty ratio of the supply current used in a first time period (T1) of the reverse rotation drive to a value larger than a current value or a duty ratio of the supply current used in a second time period (T2) of the reverse rotation drive, the first time period (T1) extending from a time point at which the reverse rotation of the crankshaft (48) is started to a predetermined time point, the second time period (T2) extending from the predetermined time point; and a battery status determination unit (126) configured to determine a status of the battery (96) based on a state of voltage of the battery (96) in the first time period (T1).

Further, the supply controller (128) is configured to set the current value or the duty ratio used in the first time period (T1) to a value which allows a piston of the engine (E) to reach beyond a top dead center, the piston being configured to change in position as the crankshaft (48) is driven in the reverse rotation direction, and to set the current value or the duty ratio used in the second time period (T2) to a value which does not allow the piston to reach beyond the top dead center.

A second aspect: The supply controller (128) sets a threshold for the current value or the duty ratio of the supply current based on a water temperature or a throttle position of the engine (E). The supply controller (128) sets the current value or the duty ratio used in the first time period (T1) to a value larger than the threshold, and sets the current value or the duty ratio used in the second time period (T2) to a value smaller than the threshold.

A third aspect: The controller (36) has a battery voltage acquirer (116) configured to detect and store a plurality of voltage values of the battery (96) in at least the first time period (T1).

A fourth aspect: The battery voltage acquirer (116) sets time intervals of detecting the voltage value of the battery (96) such that the time intervals in the first time period (T1) are shorter than the time intervals in the second time period (T2).

A fifth aspect: The supply controller (128) sets the current value or the duty ratio used when starting the drive in the normal rotation direction to a value which is substantially same as the current value or the duty ratio used in the first time period (T1).

A sixth aspect: The controller (36) has an idle-stop controller (124) configured to perform idle-stop control which automatically stops the engine (E) while a vehicle is stopped, and the controller (36) forbids operation of the idle-stop controller (124) if the battery status determination unit (126) determines that the battery (96) is in an abnormal state.

### Effects of the Invention

According to the first aspect of the present invention, the supply controller sets the current value or the duty ratio of the supply current used in the first time period to a value larger than the current value or the duty ratio of the supply current used in the second time period. Thus, the battery can be given high load at an initial stage of the reverse rotation drive (the first time period). Additionally, utilizing this first time period, the battery status determination unit monitors the status of voltage of the battery. This enables precise determination of the status (such as charge level and deterioration) of the battery. Further, in the second time period (which comes after the first time period), the current value or the duty ratio of the supply current is decreased to prevent the piston connected to the crankshaft from reaching beyond the top dead center and to allow suppression of a decrease in the charge level of the battery.

Further, the current value or the duty ratio of the supply current in the first time period is set to a value which allows the piston to reach beyond the top dead center. Thus, sufficiently high load can be applied to the battery, and by monitoring a change in the voltage of the battery given such load, the status of the battery can be determined even more precisely.

Further, the current value or the duty ratio in the second time period is set to a value which does not allow the piston to reach beyond the top dead center. Thus, the piston can be prevented from reaching beyond the top dead center during the reverse rotation drive. Further, power consumed by the battery during the reverse rotation drive of the crankshaft can be reduced.

According to the second aspect of the present invention, a threshold for the current value or the duty ratio of the supply current is set based on the water temperature or the throttle position of the engine. Thus, the piston can be prevented even more surely from reaching beyond the top dead center during the reverse rotation drive.

According to the third aspect of the present invention, the battery voltage acquirer detects and stores multiple voltage values of the battery in the first time period. Thus, a change in voltage in the first time period can be acquired even more precisely.

According to the fourth aspect of the present invention, the time intervals of detecting the voltage value of the battery are set such that the time intervals in the first time period are shorter than the time intervals in the second time period. Thus, the battery voltage acquirer can surely acquire a value of the battery voltage which has dropped the most. This allows accurate detection of a change in voltage after the reverse rotation drive is started, and also allows the first time period to be shortened. Moreover, by making the detection time intervals for the voltage value long in the second time period, load on the controller can be reduced.

According to the fifth aspect of the present invention, the supply controller sets the current value or the duty ratio used when starting the drive in the normal rotation direction to a value which is substantially the same as the current value or the duty ratio used in the first time period. Thus, control of the supply current can be performed in the same way for the reverse rotation drive and the start of the normal rotation drive, and this facilitates the control.

According to the sixth aspect of the present invention, the idle-stop control can be forbidden if the battery status determination unit determines that the battery is in an abnormal state. This ensures that the engine can be restarted during the idle-stop control.

### Brief Description of the Drawings

- Fig. 1: is a schematic side view of a scooter-type motorcycle having an engine control device according to one embodiment of the present invention.
- Fig. 2: is a front sectional view showing a swing unit of the scooter-type motorcycle in Fig. 1.
- Fig. 3: is a block diagram showing a control system of an engine of the scooter-type motorcycle in Fig. 1.
- Fig. 4: is a block diagram showing the configuration of a main portion for controlling the drive of a motor in Fig. 3.
- Fig. 5: is a graph showing a relation between a duty ratio of a supply current and a rotation angle of a crankshaft during swing-back control.
- Fig. 6: is a graph showing changes in the supply current and battery voltages in a first time period in Fig. 5.
- Fig. 7: is a flowchart showing operation performed by the engine control device when starting the engine.
- Fig. 8: is a flowchart showing operation of a battery status determination subroutine.

### Modes for Carrying Out the Invention

A preferred embodiment of an engine control device according to the present invention is described in detail below with reference to the drawings attached hereto.

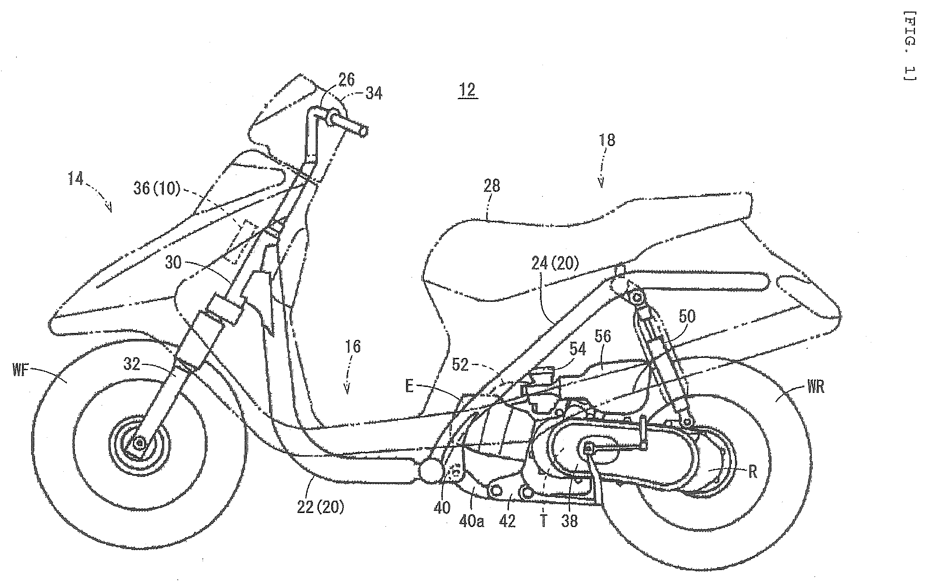

As shown in Fig. 1, an engine control device 10 according to one embodiment of the present invention is installed in a scooter-type motorcycle 12 (also referred to simply as a scooter 12 below). Note that the engine control device 10 of the present invention is not limited to being installed in the scooter 12, but is also applicable to a motorcycle of a different type, an automobile, or the like.

In the scooter 12, a vehicle-body front portion 14 and a vehicle-body rear portion 16 are connected to each other via a low floor portion 18. A vehicle body frame 20 of the scooter 12 includes a downpipe 22 extending in a curved manner from the vehicle-body front portion 14 to the low floor portion 18 and a main pipe 24 being connected to a rear portion of the downpipe 22 and extending rearward and obliquely upward over the vehicle-body rear portion 16. A handlebar 26 is provided at the vehicle-body front portion 14 (a front side of the downpipe 22), and a seat 28 is provided at an upper portion of the vehicle-body rear portion 16 (the main pipe 24).

The handlebar 26 is pivotally supported by a head pipe 30 connected to the downpipe 22 and extends upward, and a front fork 32 which pivotally supports a front wheel WF such that the front wheel WF can rotate is attached to a lower portion of the head pipe 30. A handlebar cover 34 also serving as an instrument panel is attached to an upper portion of the handlebar 26. An ECU 36 constituting the engine control device 10 is provided in front of the head pipe 30.

A bracket 40 which supports a swing unit 38 is provided at a portion where the downpipe 22 and the main pipe 24 are connected, and the bracket 40 supports two hanger brackets 42 via a link member 40a such that they can swing. The swing unit 38 is swingably provided at the vehicle body by the hanger brackets 42.

The swing unit 38 includes an engine E, a continuously variable transmission T, and a reducer mechanism R (rear wheel bearing) that are formed into an integral unit. Specifically, the four-stroke, single-cylinder engine E is provided at a front portion of the swing unit 38, the continuously variable transmission T is provided behind the engine E, and a rear wheel WR is pivotally supported by an output shaft of the reducer mechanism R. The engine E is of a water-cooled type in which a radiator 39 circulates a coolant, and has provided therein a piston (not shown), a connecting rod 46, and a crankshaft 48.

A rear portion of the swing unit 38 is supported by a bent portion of the main pipe 24 via a rear shock unit 50. Further, an air cleaner 56 and a throttle body 54 of a fuel injection device connected to an intake pipe 52 extending from the engine E are provided above the swing unit 38.

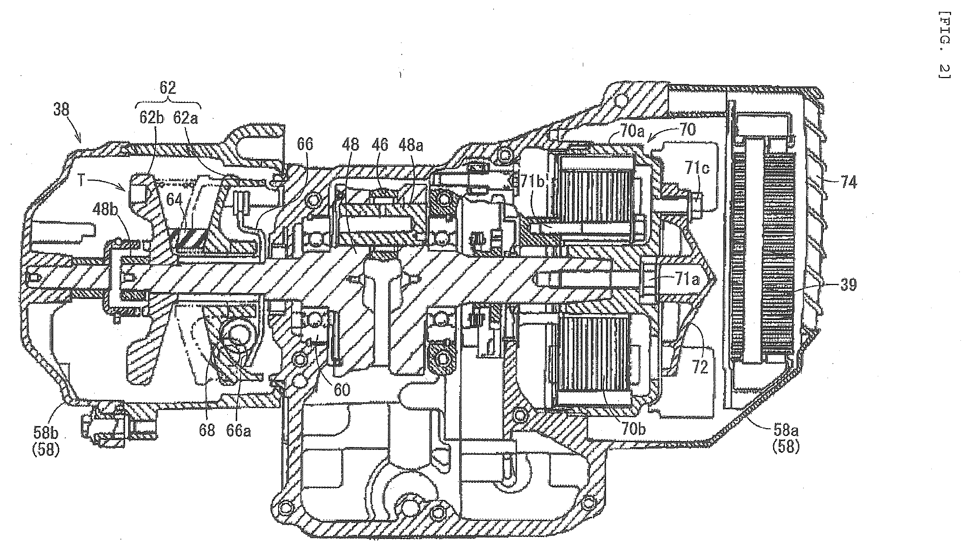

As shown in Fig. 2, the swing unit 38 has a crankcase 58 consisting of a right case 58a on the right side in a vehicle width direction and a left case 58b on the left side in the vehicle width direction. The crankshaft 48 is rotatably supported by a bearing 60 fixed to the crankcase 58. The connecting rod 46 is connected to the crankshaft 48 via a crankpin 48a, and the piston which changes in position in a cylinder of the engine E is provided at an upper portion of the connecting rod 46.

The left case 58b also serves as a case for housing the continuously various transmission T, and a belt driving pulley 62 is attached to a left end portion of the crankshaft 48, the belt driving pulley 62 having a movable-side pulley half 62a and a fixed-side pulley half 62b. A V belt 64 is wound around the belt driving pulley 62 (between the movable-side pulley half 62a and the fixed-side pulley 62b). The fixed-side pulley half 62b is fixed to a left end portion of the crankshaft 48 with a nut 48b. The movable-side pulley half 62a is spline-fitted to the crankshaft 48 and allowed to move axially.

On the right side of the movable-side pulley half 62a, a lamp plate 66 is fixed to the crankshaft 48. The lamp plate 66 has a tapered surface 66a formed on its outer circumferential portion, the tapered surface 66a inclining toward the movable-side pulley half 62a as it goes outward radially. Multiple weight rollers 68 are housed between the tapered surface 66a and the movable-side pulley half 62a.

As the rotation speed of the crankshaft 48 increases, the weight rollers 68 move outward radially by centrifugal force. Thereby, the movable-side pulley half 62a moves leftward in Fig. 2, approaching the fixed-side pulley half 62b. As a result, the V belt 64 sandwiched by the pulley halves 62a and 62b moves outward radially, making its winding diameter large. A driven pulley (not shown) configured to change the winding diameter of the V belt 64 in accordance with the movement of the belt driving pulley 62 is provided behind the swing unit 38. Driving force of the engine E is automatically adjusted by the continuously variable transmission T and transmitted to the rear wheel WR via a centrifugal clutch (not shown) and the reducer mechanism R (see Fig. 1).

An ACG starter motor 70 combining a starter motor and an AC generator (referred to simply as a motor 70 below) is provided inside the right case 58a. The motor 70 includes an outer rotor 70a fixed to a tip end tapered portion of the crankshaft 48 with an attachment bolt 71 a and a stator 70b placed on an inner side of the outer rotor 70a and fixed to the right case 58a with an attachment bolt 71 b. Outside of a blast fan 72 fixed to the outer rotor 70a with an attachment bolt 71c, the radiator 39 and a cover member 74 having multiple slits formed therein are attached.

Thus, the motor 70 is configured to be capable of driving and rotating the crankshaft 48 without gears and the like, and can restart the scooter 12 smoothly during, for example, an idle-stop. The rotational driving of the motor 70 is controlled by the ECU 36 in start-up of the engine E, an idle-stop, or the like.

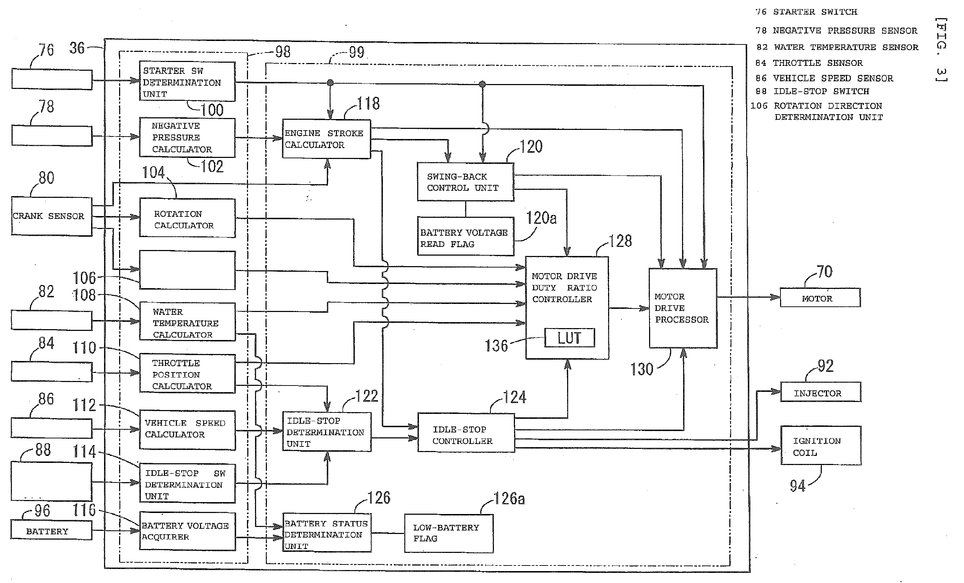

The ECU 36 is configured with an electronic circuit having a microcomputer, a memory, an interface (none of which is shown), and the like, and controls not only the motor 70 but also other electrical systems installed in the scooter 12. As shown in Fig. 3, elements connected to an input side of the ECU 36 are a starter switch 76, a negative pressure sensor 78, a crank sensor 80, a water temperature sensor 82, a throttle sensor 84, a vehicle speed sensor 86, an idle-stop switch 88, a battery 96, and the like. Elements connected to an output side of the ECU 36 are the motor 70 constituting an electrical system of the engine E, an injector 92, an ignition coil 94, and the like. The ECU 36 receives outputs (electric signals) from the switches and sensors via an interface, performs programmed processing using the outputs, and thereby controls the electric system of the engine E.

The starter switch 76 is provided at, for example, a position near the handlebar 26, and has a function of starting the motor 70 (i.e., the engine E) when a user turns on the starter switch 76. The negative pressure sensor 78 is provided at the intake pipe 52 of the engine E, detects an intake air mass (negative pressure) based on internal pressure of the intake pipe 52 which is converted into a change in voltage, and outputs a detection signal proportional to the negative pressure. The crank sensor 80 is provided at a portion where the crankshaft 48 is housed, detects a protrusion or the like provided at the circumferential surface of the crankshaft 48, and outputs a crank pulse signal. The water temperature sensor 82 is provided in a coolant circulation path inside the engine E and outputs a detection signal proportional to the temperature of the coolant. The throttle sensor 84 is provided at a position near a handlebar grip, detects a throttle position (rotation amount) operated by a user, and outputs a detection signal according to the position. The vehicle speed sensor 86 is provided at a position near an axle, and outputs a vehicle speed pulse signal proportional to the number of rotations of the axle. The idle-stop switch 88 is for causing the scooter 12 to perform idle-stop control when it is turned on by the user, and is provided at a position near the handlebar 26, as the starter switch 76 is.

On the other hand, the motor 70 connected to the output side of the ECU 36 operates the piston by applying toque to the crankshaft 48 when causing the engine E to transition from a stopped state to an operated state (an intake stroke, a compression stroke, a combustion and expansion stroke, and an exhaust stroke). The injector 92 is attached to an intake system of the engine E and injects fuel from a fuel injection nozzle. The ignition coil 94 is connected to an ignition plug of the engine E and outputs high voltage to the ignition plug at predetermined timing.

Programs executed by the ECU 36 are divided, by function, into an input-system control part 98 which mainly performs initial processing based on output results from the switches and sensors, and an output-system control part 99 which receives signals from the input-system control part 98 and controls the electrical system of the engine E.

The input-system control part 98 has, corresponding to the sensors and switches described above, a starter SW determination unit 100, a negative pressure calculator 102, a rotation calculator 104, a rotation direction determination unit 106, a water temperature calculator 108, a throttle position calculator 110, a vehicle speed calculator 112, an idle-stop SW determination unit 114, and a battery voltage acquirer 116.

The starter SW determination unit 100 is configured to receive an ON/OFF signal outputted by the starter switch 76 and determines whether a user wishes to start the engine E or not. The negative pressure calculator 102 is configured to calculate the negative pressure inside the intake pipe 52 based on the detection signal outputted by the negative pressure sensor 78. The rotation calculator 104 is configured to calculate the number of rotations of the crankshaft 48, i.e., the rotation speed of the engine E, based on the crank pulse signal outputted by the crank sensor 80. The rotation direction determination unit 106 is configured to determine the rotation direction (normal rotation or reverse rotation) of the crankshaft 48 based on, again, the crank pulse signal. The water temperature calculator 108 is configured to calculate the temperature of the coolant circulating in the engine E, based on the detection signal outputted by the water temperature sensor 82. The throttle position calculator 110 is configured to receive the detection signal outputted by the throttle sensor 84 and calculates the position of the throttle operated by the user. The vehicle speed calculator 112 is configured to calculate the travelling speed of the vehicle based on a vehicle speed pulse signal outputted by the vehicle speed sensor 86. The idle-stop SW determination unit 114 is configured to receive an ON/OFF signal outputted from the idle-stop switch 88 and determine whether the user has intension of performing the idle-stop control.

The battery voltage acquirer 116 samples, at predetermined time intervals, voltage supplied by the battery 96 thereto continuously (in an analog manner) and stores them in the memory of the ECU 36. The battery voltage acquirer 116 is also configured to monitor a battery voltage read flag 120a of a swing-back controller 120 to be described later, and to read the battery voltage at sampling intervals shorter than regular intervals when the battery voltage read flag 120a is set to 1.

The output-system control part 99 of the ECU 36, on the other hand, has an engine stroke calculator 118, the swing-back controller 120, an idle-stop determination unit 122, an idle-stop controller 124, a battery status determination unit 126, a motor drive duty ratio controller 128 (supply controller), and a motor drive processor 130.

The engine stroke calculator 118 has a function of determining the present stroke of the engine E based on a value of the negative pressure inside the intake pipe 52 calculated by the negative pressure calculator 102 and the crank pulse signal outputted by the crank sensor 80. For example, the four-stroke engine E is assigned stages each having 10° in accordance with the crankshaft 48 which rotates twice (rotates by 720°) in one cycle (see JP-A-2010-223135). Then, by the crank pulse signal outputting one pulse for each stage, the current rotation angle of the crankshaft 48, i.e., the current stage of the engine E can be found easily and precisely.

The swing-back controller 120 is configured to perform swing-back control when starting the engine E. In the swing-back control, the motor 70 drives the crankshaft 48 in the reverse rotation direction, and after the reverse rotation drive, drives the crankshaft 48 in the normal rotation direction. The swing-back controller 120 starts operation upon receipt of a signal indicating that the starter switch 76 is on, from the starter SW determination unit 100. Then, after starting operation, the swing-back controller 120 receives, as input, the rotation angle of the crankshaft 48 outputted by the engine stroke calculator 118. Further, the swing-back controller 120 has the battery voltage read flag 120a (register) used for shortening the intervals of sampling the battery voltage during an initial stage of the swing-back control (a first time period T1 to be described later). Operation of the swing-back control will be described in detail later.

The idle-stop determination unit 122 has a function of determining whether or not to perform the idle-stop control when the scooter 12 stops while travelling. The idle-stop determination unit 122 receives, as input, the throttle position calculated by the throttle position calculator 110 and the vehicle travelling speed calculated by the vehicle speed calculator 112. When the throttle position and the vehicle speed reach or fall below their predetermined values, the idle-stop determination unit 122 outputs, to the idle-stop controller 124, a command signal commanding to perform the idle-stop control. Further, the idle-stop determination unit 122 is configured to receive a command signal from the idle-stop SW determination unit 114 and prompt execution of the idle-stop control based on an assumption that the idle-stop switch 88 is on. The idle-stop determination unit 122 is also configured to monitor a low-battery flag 126a of the battery status determination unit 126 to be described later, and when the low-battery flag 126a is set to 1, forbid the idle-stop control even if the idle-stop switch 88 is turned on.

The idle-stop controller 124 performs the idle-stop control based on a command signal from the idle-stop determination unit 122. In the idle-stop control, the idle-stop controller 124 performs control to stop driving of the injector 92 and the ignition coil 94. Thereby, the engine E of the scooter 12 is automatically stopped. In addition, the idle-stop controller 124 outputs control signals to the motor drive duty ratio controller 128 and the motor drive processor 130, and performs control in which the crankshaft 48 is driven in the reverse rotation direction while the vehicle is stopped based on the rotation angle of the crankshaft 48 and is driven in the normal rotation direction when the vehicle is to restart. Specific operation of the motor 70 and the engine E approximates the swing-back control, and is therefore not described in detail.

The battery status determination unit 126 has a function of determining the status (e.g., charge level and deterioration state) of the battery 96 installed in the scooter 12. Specifically, the battery status determination unit 126 estimates the charge level of the battery 96 (or deterioration of the battery 96) by causing the ECU 36 to perform control to apply high load to the battery 96 (to make the battery 96 output high power) and then monitoring a change in voltage caused by that high load application. The battery status determination unit 126 receives, as input, the water temperature calculated by the water temperature calculator 108 and the battery voltages acquired by the battery voltage acquirer 116. The battery status determination unit 126 sets a low-battery judgment threshold based on the water temperature, and when the battery voltage under the high load is lower than the low-battery judgment threshold, determines that the battery's charge level is low, and turns on the low-battery flag 126a (sets the flag to 1).

The motor drive duty ratio controller 128 sets a duty ratio of power supplied from the battery 96 to the motor 70 (supply current). The motor drive duty ratio controller 128 receives, as input, the rotation speed of the engine E from the rotation calculator 104, the rotation direction of the crankshaft 48 from the rotation direction determination unit 106, the water temperature from the water temperature calculator 108, and the throttle position from the throttle position calculator 110. The motor drive duty ratio controller 128 also receives, as input, control signals from the swing-back controller 120 and the idle-stop controller 124, and appropriately changes the duty ratio according to the control signals.

The motor drive processor 130 starts operation upon receipt of a signal indicating that the starter switch 76 is on from the starter SW determination unit 100, and controls the drive of the motor 70. The motor drive processor 130 receives, as input, the stage of the engine E outputted by the engine stroke calculator 118, a control signal for the swing-back control outputted by the swing-back controller 120, the duty ratio outputted by the motor drive duty ratio controller 128, and a control signal for the idle-stop control outputted by the idle-stop controller 124.

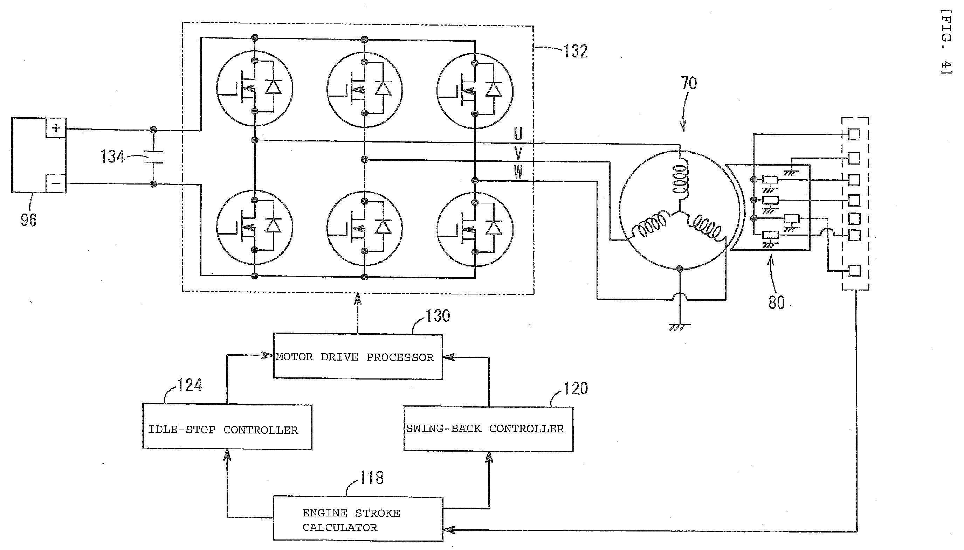

More specifically, the motor drive processor 130 performs the swing-back control or the idle-stop control when the engine E is to be started or when the vehicle is stopped. In these controls, the motor drive processor 130 controls switching between reverse rotation drive and normal rotation drive of the crankshaft 48, and at the same time, controls the rotation drive of the motor 70 based on the duty ratio set by the motor drive duty ratio controller 128 (see Fig. 4).

As shown in Fig. 4, as a driver of the motor 70, a full-wave rectifying bridge circuit 132 is provided at the output side (ECU 36) of the motor drive processor 130. The full-wave rectifying bridge circuit 132 is formed by parallel-connecting three pairs of series-connected power FETs. A smoothing capacitor 134 is parallel-connected between the battery 96 and the full-wave rectifying bridge circuit 132. The motor drive processor 130 can control power supplied from the battery 96 to the motor 70 through switching of the power FETs.

The motor 70 is a three-phase motor receiving a three-phase AC from the full-wave rectifying bridge circuit 132, and upon receipt of maximum power (e.g., a supply current having a duty ratio of 100%) from the battery 96 via the full-wave rectifying bridge circuit 132, the motor 70 can rotate (apply torque to) the crankshaft 48 so that the piston can reach beyond the compression top dead center.

As already described, when the engine E is to be started, the ECU 36 and the motor 70 configured as above perform the swing-back control in which the crankshaft 48 is driven in the reverse rotation direction and then in the normal rotation direction. This swing-back control is described below.

In the swing-back control, first, the engine stroke calculator 118 detects (calculates) the stage of the engine E to find the rotation angle of the crankshaft 48. The swing-back control is particularly performed in order to extend the run-up length for the piston so that the piston can reach beyond the compression top dead center. However, depending on the rotation angle of the crankshaft 48, the run-up length is already large, and therefore the swing-back control may not have to be performed.

For the reason above, the swing-back controller 120 determines based on the rotation angle of the crankshaft 48 whether or not to perform the swing-back control. Then, when determining that the swing-back control is to be performed, the swing-back controller 120 outputs a control start signal to the motor drive duty ratio controller 128 and the motor drive processor 130.

Upon receipt of the control start signal from the swing-back controller 120, to perform the reverse rotation drive of the crankshaft 48, the motor drive processor 130 changes timing for issuing a drive command to the power FETs of the full-wave rectifying bridge circuit 132. Further, the motor drive duty ratio controller 128 outputs a duty ratio used in the reverse rotation drive, and the motor drive processor 130 rotates the motor 70 based on this duty ratio, driving the crankshaft 48 in the reverse rotation direction.

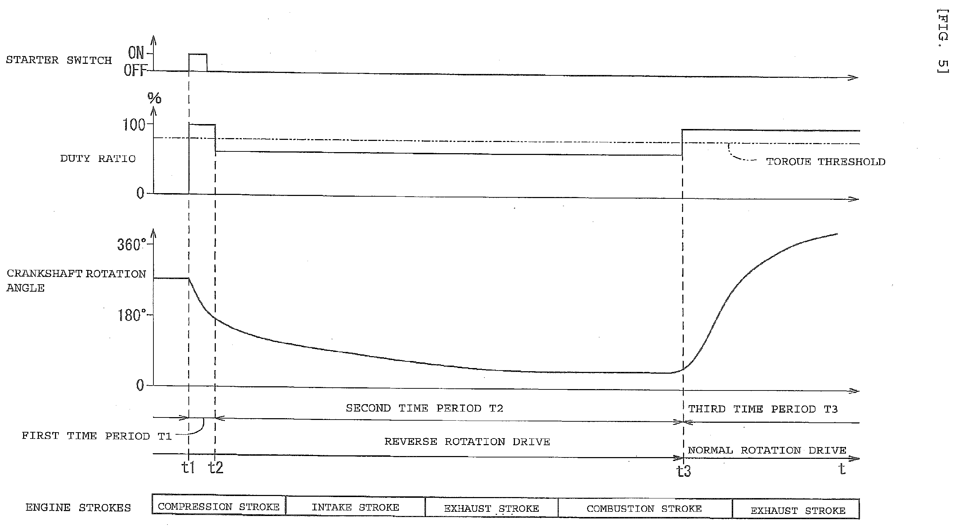

As shown in Fig. 5, once the engine E reaches the combustion stroke during the reverse rotation drive, the piston changes in position upward, increasing the internal pressure of the combustion chamber of the engine E. Consequently, the compression reaction force received by the piston from the combustion chamber decreases the rotation speed of the motor 70, and at that timing, the motor 70 is shifted from the reverse rotation drive to the normal rotation drive.

In this event, the crankshaft 48 can be rotated with momentum in the normal rotation direction by the output from the motor 70 and the compression reaction force of the piston. Further, since the run-up length till the compression top dead center is sufficiently large, the motor 70 can rotate the crankshaft 48 so that the piston can easily reach beyond the compression top dead center. In other words, the vehicle can smoothly initiate start-up of the engine E by performing the swing-back control.

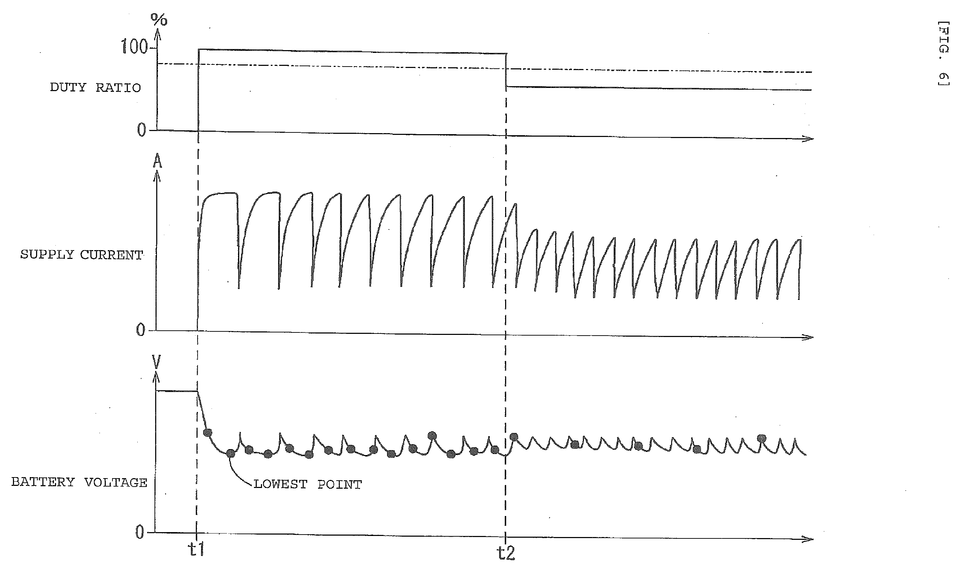

Next, based on Figs. 5 and 6, a description is given of a relation between the control of the duty ratio of the supply current supplied from the battery 96 to the motor 70 and determination of the battery status during the swing-back control described above. During the reverse rotation drive of the crankshaft 48, the piston might change in position upward to reach beyond the top dead center if the motor 70 is supplied with high output power from the battery 96 and applies excessive torque to the crankshaft 48 for a certain period of time or longer. On the other hand, to precisely determine the status of the battery 96 (such as charge level or deterioration), it is required to make the output of the battery 96 high enough and then detect the voltage drop. For these reasons, the engine control device 10 of this embodiment is configured to change the duty ratio of the supply current to the motor 70 while the swing-back control is performed.

Before the engine E is started, the starter switch 76 (or an ignition key) is off to block power supply from the battery 96. Thus, the duty ratio is 0%. When a user turns on the starter switch 76 at a time point t1 (reverse rotation start point), the motor drive duty ratio controller 128 receives a control start signal from the swing-back controller 120.

Upon receipt of the control start signal, the motor drive duty ratio controller 128 sets the duty ratio of the supply current to 100%, which is the maximum value. Thereby, the motor drive processor 130 controls the full-wave rectifying bridge circuit 132 so that the duty ratio of the supply current from the battery 96 may become 100%, and the motor 70 applies high torque to the crankshaft 48 at an initial stage of the start-up of the engine E. As a result, the rotation speed of the crankshaft 48 is increased.

The motor drive duty ratio controller 128 changes the 100% duty ratio of the supply current at a time point t2 (predetermined time point) which is a point reached after a lapse of a predetermined period of time. The first time period T1 (between the time points t1 and t2) during which the duty ratio is set to 100% can be preset to any appropriate duration according to the model of the engine E, the functionality of the motor 70, or the like, and may be preferably set to, for example, in the vicinity of 100 ms. It is more preferable, for example, to set a long duration when the torque of the motor 70 is relatively low, and a short duration when the torque is relatively high.

The ECU 36 according to this embodiment is configured to acquire battery voltage and determine the status of the battery 96 in the first time period T1 during which the duty ratio of the supply current from the battery 96 is set to 100%.

Specifically, the battery voltage acquirer 116 acquires a battery voltage of the battery 96 when start-up of the engine E is to be initiated (or before the start-up of the engine E, i.e., when the ignition key is on but the starter switch 76 is off), and stores the battery voltage as an initial voltage. Thereafter, after the start-up of the engine is initiated, the battery voltage acquirer 116 samples successive voltages of the battery 96 at predetermined time intervals in the first time period T1, and stores them in the memory as multiple detected voltages.

Here, by detecting that the battery voltage read flag 120a of the swing-back controller 120 is set to 1, the battery voltage acquirer 116 makes the sampling intervals shorter than those in a second time period T2 which starts from the time point t2 and reads the battery voltages at those sampling intervals. Thereby, the battery voltages in the first time period T1 can be detected precisely.

The battery status determination unit 126 searches for the lowest battery voltage (i.e., one at the lowest point) among the multiple detected voltages sampled in the first time period T1, and specifies the value thereof.

Further, the battery status determination unit 126 sets a low-battery judgment threshold based on the water temperature inputted from the water temperature calculator 108, and compares the calculated battery voltage with this low-battery judgment threshold. More specifically, the drive status of the engine E is influenced and changed by temperature (water temperature). Thus, by setting the low-battery judgment threshold according to the water temperature, the status of the battery 96 matching usage conditions of the motor 70 can be determined.

The battery 96 having a low charge level or being deteriorated shows a sufficient voltage value when no load is applied thereto, but shows a drastic change (voltage drop) when load is applied thereto. Thus, if the battery voltage is smaller than the low-battery judgment threshold, it can be assumed that the battery 96 is running low. For this reason, when determining that the battery voltage is smaller than the low-battery judgment threshold, the battery status determination unit 126 outputs, to the idle-stop determination unit 122, a signal indicating that the idle-stop control cannot be performed. Upon receipt of this signal, the idle-stop determination unit 122 stops the idle-stop control even if other conditions for the idle-stop control are satisfied. Thereby, when the battery 96 is running low (or is deteriorated), execution of the idle-stop control can be refrained surely while the vehicle is travelling.

Referring back to Fig. 5, in the second time period T2 which starts from the time point t2, the motor drive duty ratio controller 128 performs control in which the duty ratio of the supply current is decreased from 100% to a predetermined ratio. The predetermined ratio is obtained as follows. Specifically, the motor drive duty ratio controller 128 estimates upper-limit torque which would not cause the piston to reach beyond the top dead center by rotation of the motor 70, and a threshold of the duty ratio is set according to this upper-limit torque (referred to as a torque threshold hereinbelow). Note that the torque threshold may be set when the reverse rotation drive is started. By setting the torque threshold in the first time period T1, the reverse rotation drive of the crankshaft 48 in the first time period T1 may be performed with a duty ratio of not only 100%, but also a ratio larger than the torque threshold.

To set the torque threshold, an appropriate value may be selected by reference to a 3D map (a LUT (lookup table) 136) prepared based on a duty ratio of supply current, water temperature, and throttle position. In outline, in response to start of the swing-back control, a water temperature is acquired from the water temperature calculator 108, and a torque threshold associated with that water temperature is selected. In this way, the torque threshold can be set with a short period of time.

For example, if a torque threshold which indicates a duty ratio of 80% is selected, the motor drive duty ratio controller 128 sets a duty ratio equal to or lower than the duty ratio of 80%. Thereby, in the reverse rotation drive of the crankshaft 48, even if the piston is changed in position by the torque from the motor 70, the piston can be prevented from reaching the compression stroke by reaching beyond the top dead center of the combustion stroke. The duty ratio in the second time period T2 is preferably set to, for example, about 75% of the torque threshold.

The second time period T2 is set to be longer than the first time period T1. Thereby, the run-up length for the normal rotation drive of the crankshaft 48 can be obtained surely, and also, power supplied by the battery 96 can be reduced. Then, at a time point t3, the ECU 36 (the swing-back controller 120) causes the crankshaft 48 to transition to the normal rotation drive with the piston being still (with the compressed fuel and the rotation of the crankshaft 48 being counterbalanced).

At an initial stage of a third time period T3 which starts from the time point t3, the motor drive duty ratio controller 128 sets the duty ratio of the supply current to 100%, as it does in the first time period T1. The motor drive processor 130 rotates the motor 70 with a duty ratio of 100%, and thereby rotates the crankshaft 48 in the normal rotation direction with large torque. Since the engine E has a large run-up length owing to the reverse rotation drive of the crankshaft 48, the crankshaft 48 and the piston can be operated with sufficient momentum, so that the piston can easily reach beyond the compression top dead center.

Note that the duty ratio (or the current value) of the supply current set in each of the first time period T1 and the second time period T2 is not limited to a single (constant) value, but may be set to multiple values. When the duty ratio is set to multiple values, the multiple values may, for example, change in a stepwise manner or change gradually in an incline manner.

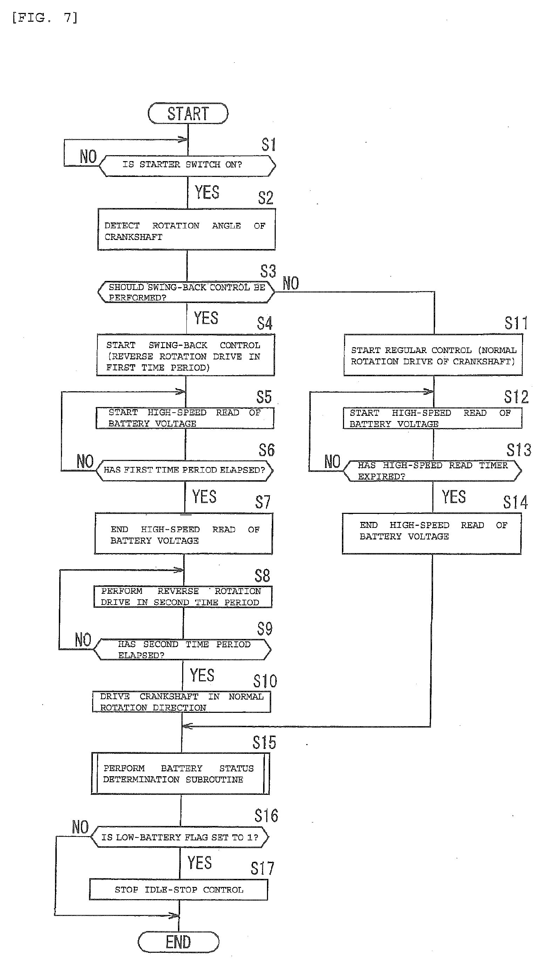

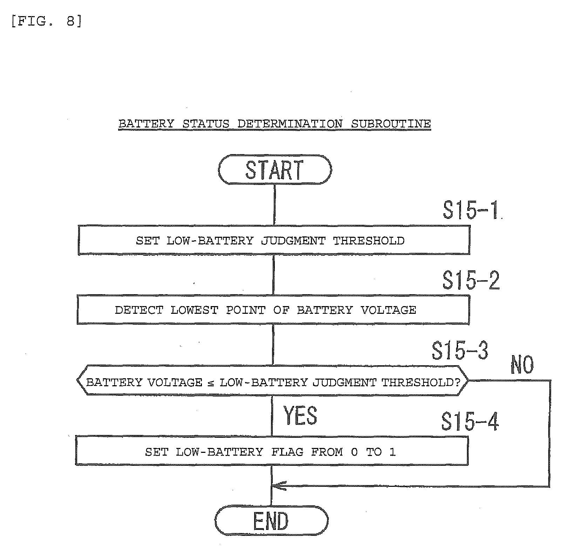

The engine control device 10 according to this embodiment is basically configured as above. Hereinbelow, based on flowcharts in Figs. 7 and 8, a specific description is given of operation of the engine control device 10 performed when the engine E is started (battery status determination flow).

When a user turns on a main switch (the ignition key), predetermined power is supplied from the battery 96 to the ECU 36, and the ECU 36 starts driving. In addition, after the main switch is turned on, power is automatically supplied from the battery 96 to electronic equipment requiring power immediately, and with this, the battery voltage acquirer 116 starts reading the battery voltage at predetermined (regular) time intervals.

Then, the starter SW determination unit 100 determines whether or not the user has turned on the starter switch 76 or not (Step S1). Flow proceeds to Step S2 if the starter switch 76 is on.

In Step S2, the engine stroke calculator 118 calculates (detects) the stage of the engine E (i.e., the rotation angle of the crankshaft 48). After Step S2, the swing-back controller 120 determines, based on the rotation angle of the crankshaft 48 thus detected, whether or not to perform the swing-back control (Step S3). Flow proceeds to Step S4 if it is determined in Step S3 that the swing-back control is to be performed, or proceeds to Step S11 if it is determined that the swing-back control is not to be performed.

In Step S4, once the swing-back control is initiated, the swing-back controller 120 outputs a control start signal to the motor drive duty ratio controller 128 and the motor drive processor 130 and also turns on the battery voltage read flag 120a (sets it from 0 to 1). With this, the motor drive duty ratio controller 128 sets the duty ratio of the supply current to 100%, and the motor drive processor 130 switches the drive of the crankshaft 48 to the reverse rotation drive. Thus, reverse rotation drive of the crankshaft 48 is started in the engine E. Further, detecting that the battery voltage read flag 120a is 1, the battery voltage acquirer 116 sets a high-speed read timer which is equal to the period during which the duty ratio is set to 100% (the first time period T1: see Fig. 5).

Thereafter, the ECU 36 drives the crankshaft 48 in the reverse rotation direction by rotating the motor 70 with a duty ratio of 100% in the first time period T1, and the battery voltage acquirer 116 performs high-speed reading of the battery voltage in this first time period T1 (period in which the high-speed read timer is on) (Step S5). Note that the "high-speed reading" means successive sampling of the battery voltage at sampling intervals set to be shorter than regular sampling intervals. The battery voltage acquirer 116 sequentially stores, in the memory, the detected voltages read in this high-speed reading.

In Step S6, the ECU 36 monitors an end of the first time period T1 (passage of the time point t2), and continues performing Step S5 if the time point t2 is not passed. Flow proceeds to Step S7 when the time point t2 is passed.

In Step S7, the swing-back controller 120 turns off the battery voltage read flag 120a (sets it to 0). Thereby, the battery voltage acquirer 116 sets the time intervals for reading the battery voltage back to the regular time intervals.

Then, once the second time period T2 which starts from the time point t2 is reached, in Step S8, the motor drive duty ratio controller 128 sets a torque threshold based on a water temperature and a throttle position in response to a command from the swing-back controller 120, and sets a duty ratio for the second time period to a value lower than the torque threshold. The motor drive processor 130 performs the reverse rotation drive of the crankshaft 48 according to the duty ratio for the second time period.

In Step S9, the swing-back controller 120 monitors an end of the second time period T2 (passage of a time point t3), and continues performing Step S8 if the time point t3 is not passed. Flow proceeds to Step S10 when the time point t3 is passed.

After the second time period T2, the swing-back controller 120 gives the motor drive processor 130 a command to switch the drive of the crankshaft 48 to the normal rotation drive, and also gives the motor drive duty ratio controller 128 a command to set the duty ratio of the supply current to 100% (Step S10). Thereby, the motor drive processor 130 performs the normal rotation drive of the crankshaft 48, and in the engine E, the piston is operated to reach beyond the compression top dead center by the rotation of the crankshaft 48 having a sufficient run-up length.

On the other hand, if it is determined in Step S3 that the reverse rotation drive of the crankshaft 48 is unnecessary, the battery voltage is read in Steps S11 to S14 while the crankshaft 48 is driven in the normal rotation direction without the reverse rotation drive performed beforehand (this normal rotation drive is also referred to as regular control below to facilitate discrimination from the swing-back control).

More specifically, once the regular control is started, in Step S11, the swing-back controller 120 outputs a signal commanding to perform the normal rotation drive to the motor drive duty ratio controller 128 and the motor drive processor 130 and also turns on the battery voltage read flag 120a (sets it from 0 to 1). Thereby, the motor drive duty ratio controller 128 sets the duty ratio of the supply current to 100%, and the motor drive processor 130 performs the normal rotation drive of the crankshaft 48 as usual. Further, detecting that the battery voltage read flag 120a is set to 1, the battery voltage acquirer 116 sets the high-speed read timer, as it does in Step S4.

Thereafter, with the crankshaft 48 being driven in the normal rotation direction, the battery voltage acquirer 116 performs the high-speed reading of the battery voltage while the above-set high-speed read timer is on (Step S12). In other words, the sampling intervals during the high-speed read timer are set shorter as they are in the swing-back control. The battery voltage acquirer 116 sequentially stores the detected voltages thus read, in the memory.

In Step S13, the ECU 36 monitors whether or not the high-speed read timer has expired or not, and continues performing Step S12 if the high-speed read timer has expired. Flow proceeds to Step S14 once the high-speed read timer expires.

In Step S14, the swing-back controller 120 turns off the battery voltage read flag 120a (sets it to 0). With this, the battery voltage acquirer 116 reads the battery voltage at the regular time intervals. Flow thereafter proceeds to Step S15 which is also reached by flow from the swing-back control.

In Step S15, a battery-status determination subroutine is started, in which the battery status is determined using the detected voltages acquired in the first time period T1 in the swing-back control or in the duration of the high-speed read timer in the regular control.

As shown in Fig. 8, in the battery-status determination subroutine, first, the battery-status determination unit 126 acquires a water temperature from the water temperature calculator 108, and sets a low-battery judgment threshold (Step S15-1).

Next, the battery-status determination unit 126 reads the multiple detected voltages stored in the memory, detects the lowest battery voltage (voltage at the lowest point) thereamong, and specifies the value thereof (Step S15-2).

After the calculation, the battery-status determination unit 126 compares the battery voltage with the low-battery judgment threshold to see which is larger (Step S15-3). Then, the battery-status determination unit 126 proceeds to Step S15-4 if the battery voltage is equal to or smaller than the low-battery judgment threshold, or skips Step S15-4 and ends the battery-status determination subroutine if the battery voltage is larger than the low-battery judgment threshold.

In Step S15-4, the battery-status determination unit 126 turns on the low-battery flag 126a (sets it from 0 to 1). With this, it is determined in the battery-status determination subroutine that the battery status is unfavorable (the battery 96 is running low).

Referring back to Fig. 7, in Step S16, the idle-stop determination unit 122 monitors the low-battery flag 126a and determines whether or not to perform the idle-stop control. If the low-battery flag 126a is set to 1, the idle-stop determination unit 122 proceeds to Step S17, and in Step S17, forbids operation for the idle-stop control. If, on the other hand, the low-battery flag 126a is set to 0, the idle-stop determination unit 122 skips Step S17.

When the above steps are finished, the battery status determination flow by the engine control device 10 is completed. Since swing-back control is performed, the piston stably reaches beyond the compression top dead center, allowing the engine E to smoothly transition to the next operation of the four strokes (the intake stroke, the compression stroke, the combustion stroke, and the exhaust stroke).

As described above, in the engine control device 10 according to this embodiment, the motor drive duty ratio controller 128 sets the duty ratio of the supply current in the first time period T1 to a value larger than the duty ratio of the supply current in the second time period T2, so that the battery 96 can be given high load during the initial stage of the reverse rotation drive (the first time period T1). Then, utilizing this first time period T1, the battery status determination unit 126 monitors the voltage status of the battery 96. This allows precise determination of the abnormal state of the battery 96 (such as its charge level or deterioration). Further, the duty ratio of the supply current is decreased in the second time period T2 (which comes after the first time period T1). This can prevent the piston connected to the crankshaft 48 from reaching beyond the top dead center, and also suppress a decrease in the charge level of the battery 96.

Note that the control of the supply current by the ECU 36 is of course not limited to the duty ratio. For example, the ECU 36 may perform control which makes the duty ratio constant but changes the current value, or control which changes both the duty ratio and the current value.

Moreover, by setting the current value or the duty ratio of the supply current used in the second time period T2 to a value which does not allow the piston to reach beyond the top dead center, the motor drive duty ratio controller 128 can prevent the piston from reaching beyond the top dead center during the reverse rotation drive. Thus, in the reverse rotation drive of the crankshaft 48, the piston can be held at a position where the run-up length is sufficiently large. In addition, power consumption by the battery 96 can be reduced in the reverse rotation drive of the crankshaft 48.

Further, since the battery voltage acquirer 116 detects multiple battery voltages in the first time period T1, a change in voltage in the first time period T1 can be precisely acquired.

Furthermore, by making the detection time intervals (sampling intervals) for the battery voltage in the first time period T1 shorter than the detection time intervals in the second time period T2, the battery voltage acquirer 116 can surely acquire a value of the battery voltage which has dropped the most. Thereby, a change in voltage after the start of the reverse rotation drive can be accurately detected, and at the same time, the first time period T1 can be shortened. Moreover, by increasing the time intervals for detection the voltage value in the second time period T2, load on the controller can be reduced.

Furthermore, the motor drive duty ratio controller 128 sets the duty ratio used in starting the normal rotation drive to a value which is substantially the same as the current value or the duty ratio used in the first time period T1. Thus, control of the supply current can be performed in the same way for the reverse rotation drive and the start of the normal rotation drive, and this facilitates the control. In addition, when determining that the battery 96 is in an abnormal state, the battery status determination unit 126 can forbid the idle-stop control. This ensures that the engine E can be restarted during the idle-stop control.

The preferred embodiment of the present invention has been described above, but the present invention is not limited to the above embodiment, and can of course be modified variously without departing from the scope of the present invention as defined in the appended claims.

The present invention is directed to detect the status of a battery by utilizing reverse rotation drive of a crankshaft at the time of engine start-up.

An engine control device 10 has an ECU 36 configured to perform, in starting an engine E, swing-back control in which a motor 70 driven based on a supply current from a battery 96 drives a crankshaft 48 in a reverse rotation direction, and after the drive in the reverse rotation direction, drives the crankshaft 48 in a normal rotation direction. The ECU 36 has: a supply controller 128 configured to set a duty ratio of the supply current used in a first time period T1 to a value larger than that used in a second time period T2, the first time period T1 extending from a time point at which the reverse rotation of the crankshaft 48 is started to a predetermined time point, the second time period T2 extending from the predetermined time point; and a battery status determination unit 126 configured to determine a status of the battery 96 based on a state of voltage of the battery 96 in the first time period T1.

## Claims

1. An engine control device (10) comprising a controller (36) configured to perform, when starting an engine (E), swing-back control in which a motor (70) driven based on a supply current from a battery (96) drives a crankshaft (48) in a reverse rotation direction, and after the drive in the reverse rotation direction, drives the crankshaft (48) in a normal rotation direction, wherein
the controller (36) has:
a supply controller (128) configured to set a current value or a duty ratio of the supply current used in a first time period (T1) of the reverse rotation drive; and
a battery status determination unit (126) configured to determine a status of the battery (96) based on a state of voltage of the battery (96) in the first time period (T1),
**characterized in that**
the supply controller (128) is configured to set the current value or duty ratio of the supply current used in the first time period (T1) of the reverse rotation drive to a value larger than a current value or a duty ratio of the supply current used in a second time period (T2) of the reverse rotation drive, the first time period (T1) extending from a time point at which the reverse rotation of the crankshaft (48) is started to a predetermined time point, the second time period (T2) extending from the predetermined time point, wherein
the supply controller (128) is configured to set the current value or the duty ratio used in the first time period (T1) to a value which allows a piston of the engine (E) to reach beyond a top dead center, the piston changing in position as the crankshaft (48) is driven in the reverse rotation direction, and to set the current value or the duty ratio used in the second time period (T2) to a value which does not allow the piston to reach beyond the top dead center.

2. The engine control device (10) according to claim 1, wherein
the supply controller (128) sets a threshold for the current value or the duty ratio of the supply current based on a water temperature or a throttle position of the engine (E), and
the supply controller (128) sets the current value or the duty ratio used in
the first time period (T1) to a value larger than the threshold, and sets the current value or the duty ratio used in the second time period (T2) to a value smaller than the threshold.

3. The engine control device (10) according to claim 1 or 2, wherein
the controller (36) has a battery voltage acquirer (116) configured to detect and store a plurality of voltage values of the battery (96) in at least the first time period (T1).

4. The engine control device (10) according to claim 3, wherein
the battery voltage acquirer (116) sets time intervals of detecting the voltage value of the battery (96) such that the time intervals in the first time period (T1) are shorter than the time intervals in the second time period (T2).

5. The engine control device (10) according to any one of claims 1 to 4, wherein
the supply controller (128) sets the current value or the duty ratio used when starting the drive in the normal rotation direction to a value which is substantially same as the current value or the duty ratio used in the first time period (T1).

6. The engine control device (10) according to any one of claims 1 to 5, wherein
the controller (36) has an idle-stop controller (124) configured to perform idle-stop control which automatically stops the engine (E) while a vehicle is stopped, and
the controller (36) forbids operation of the idle-stop controller (124) if the battery status determination unit (126) determines that the battery (96) is in an abnormal state.

## Patentansprüche

1. Motorsteuerungsvorrichtung (10), die einen Controller (36) aufweist, der konfiguriert ist, um beim Starten eines Verbrennungsmotors (E) eine Rückschwingsteuerung durchzuführen, in der ein Elektromotor (70), der basierend auf einem Zufuhrstrom von einer Batterie (96) angetrieben wird, eine Kurbelwelle (48) in Rückwärtsdrehrichtung antreibt und, nach dem Antrieb in der Rückwärtsdrehrichtung, die Kurbelwelle (48) in normaler Drehrichtung antreibt, wobei
die Steuereinrichtung (36) aufweist:
einen Zufuhrcontroller (128), der konfiguriert ist, um einen Stromwert oder ein Tastverhältnis des Zufuhrstroms zu setzen, der oder das in einer ersten Zeitperiode (T1) des Rückwärtsdrehantriebs verwendet wird; und
eine Batteriezustandbestimmungseinheit (126), die konfiguriert ist, um einen Zustand der Batterie (96) basierend auf einem Spannungszustand der Batterie (96) in der ersten Zeitperiode (T1) zu bestimmen,
**dadurch gekennzeichnet,**
**dass** der Zufuhrcontroller (128) konfiguriert ist, um den Stromwert oder das Tastverhältnis des Zufuhrstroms, der oder das in der ersten Zeitperiode (T1) des Rückwärtsdrehantriebs verwendet wird, auf einen größeren Wert als einen Stromwert oder ein Tastverhältnis des Zufuhrstroms zu setzen, der oder das in einer zweiten Zeitperiode (T2) des Rückwärtsdrehantriebs verwendet wird, wobei sich die erste Zeitperiode (T1) von einem Zeitpunkt, zu dem die Rückwärtsdrehung der Kurbelwelle (48) beginnt, bis zu einem vorbestimmten Zeitpunkt erstreckt, wobei sich die zweite Zeitperiode (T2) ab dem vorbestimmten Zeitpunkt erstreckt, wobei
der Zufuhrcontroller (128) konfiguriert ist, um den Stromwert oder das Tastverhältnis, der oder das in der ersten Zeitperiode (T1) verwendet wird, auf einen Wert zu setzen, der erlaubt, dass ein Kolben des Verbrennungsmotors (E) über einen oberen Totpunkt hinweg reicht, wobei sich die Position des Kolbens ändert, wenn die Kurbelwelle (48) in der Rückwärtsdrehrichtung angetrieben wird, und um den gegenwärtigen Stromwert oder das Tastverhältnis, der oder das in der zweiten Zeitperiode (T2) verwendet wird, auf einen Wert zu setzen, der nicht erlaubt, dass der Kolben über den oberen Totpunkt hinaus reicht.

2. Die Motorsteuerungsvorrichtung (10) nach Anspruch 1, wobei
der Zufuhrcontroller (128) einen Schwellenwert für den Stromwert oder das Tastverhältnis des Zufuhrstroms basierend auf einer Wassertemperatur oder einer Drosselstellung des Verbrennungsmotors (E) setzt, und
der Zufuhrcontroller (128) den Stromwert oder das Tastverhältnis, der oder das in der ersten Zeitperiode (T1) verwendet wird, auf einen größeren Wert als der Schwellenwert setzt, und den Stromwert oder das Tastverhältnis, der oder das in der zweiten Zeitperiode (T2) verwendet wird, auf einen kleineren Wert als der Schwellenwert setzt.

3. Die Motorsteuerungsvorrichtung (10) nach Anspruch 1 oder 2, wobei
der Controller (36) eine Batteriespannungserfassungseinrichtung (116) aufweist, die konfiguriert ist, um eine Mehrzahl von Spannungswerten der Batterie (96) in zumindest der ersten Zeitperiode (T1) zu detektieren und zu speichern.

4. Die Motorsteuerungsvorrichtung (10) nach Anspruch 3, wobei die Batteriespannungserfassungseinrichtung (116) Zeitintervalle der Detektion des Spannungswerts der Batterie (96) derart setzt, dass die Zeitintervalle in der ersten Zeitperiode (T1) kürzer sind als die Zeitintervalle in der zweiten Zeitperiode (T2).

5. Die Motorsteuerungsvorrichtung (10) nach einem der Ansprüche 1 bis 4, wobei der Zufuhrcontroller (128) den Stromwert oder das Tastverhältnis, der oder das beim Antriebsbeginn in der normalen Drehrichtung verwendet wird, auf einen Wert setzt, der im Wesentlichen gleich dem Stromwert oder dem Tastverhältnis ist, der oder das in der ersten Zeitperiode (T1) verwendet wird.

6. Die Motorsteuerungsvorrichtung (10) nach einem der Ansprüche 1 bis 5, wobei der Controller (36) einen Leerlaufstoppcontroller (124) aufweist, der konfiguriert ist, um eine Leerlaufstoppsteuerung durchzuführen, die den Verbrennungsmotor (E) automatisch stoppt, während ein Fahrzeug gestoppt wird, und
der Controller (36) den Betrieb des Leerlaufstoppcontrollers (124) verbietet, wenn die Batteriezustandbestimmungseinheit (126) bestimmt, dass die Batterie (96) in einem abnormalen Zustand ist.

## Revendications

1. Dispositif de contrôle de moteur (10) comprenant un contrôleur (36) configuré pour effectuer, lors du démarrage d'un moteur (E), un contrôle oscillant arrière, dans lequel un moteur (70) entraîné sur la base d'un courant d'alimentation depuis une batterie (96) entraîne un vilebrequin (48) dans un sens de rotation inverse et après l'entraînement dans le sens de rotation inverse, entraîne le vilebrequin (48) dans un sens de rotation normal, dans lequel
le contrôleur (36) a :
un contrôleur d'alimentation (128) configuré pour établir une valeur de courant ou un facteur de marche du courant d'alimentation utilisé pendant une première période de temps (T1) de l'entrainement de rotation inverse ; et
une unité de détermination d'état de la batterie (126) configurée pour déterminer un état de la batterie (96) sur la base d'un état de tension de la batterie (96) dans la première période de temps (T1),
**caractérisé en ce que**
le contrôleur d'alimentation (128) est configuré pour établir la valeur de courant ou le facteur de marche du courant d'alimentation utilisé pendant la première période de temps (T1) de l'entrainement de rotation inverse à une valeur supérieure à une valeur de courant ou à un facteur de marche du courant d'alimentation utilisé pendant une seconde période de temps (T2) de l'entraînement de rotation inverse, la première période de temps (T1) s'étendant depuis un instant auquel la rotation inverse du vilebrequin (48) débute jusqu'à un instant prédéterminé, la seconde période de temps (T2) s'étendant depuis l'instant prédéterminé, dans lequel
le contrôleur d'alimentation (128) est configuré pour régler la valeur de courant ou le facteur de marche utilisé pendant la première période de temps (T1) à une valeur qui permet à un piston du moteur (E) de dépasser un point mort haut, le piston changeant de position quand le vilebrequin (48) est entraîné dans le sens de rotation inverse, et d'établir la valeur de courant ou le facteur de marche utilisé pendant la seconde période de temps (T2) à une valeur qui ne permet pas au piston de dépasser le point mort haut.

2. Dispositif de contrôle de moteur (10) selon la revendication 1, dans lequel le contrôleur d'alimentation (128) établit un seuil pour la valeur de courant ou le facteur de marche du courant d' alimentation, sur la base d'une température de l'eau ou d'une position d'accélérateur du moteur (E), et
le contrôleur d'alimentation (128) établit la valeur de courant ou le facteur de marche utilisé pendant la première période de temps (T1) à une valeur supérieure au seuil, et établit la valeur de courant ou le facteur de marche utilisé pendant la seconde période de temps (T2) à une valeur inférieure au seuil.

3. Dispositif de contrôle de moteur (10) selon la revendication 1 ou 2, dans lequel le contrôleur (36) dispose d'un acquéreur de tension de batterie (116) configuré pour détecter et stocker une pluralité de valeurs de tension de la batterie (96) pendant au moins la première période de temps(T1).

4. Dispositif de contrôle de moteur (10) selon la revendication 3, dans lequel l'acquéreur de tension de batterie (116) établit des intervalles de temps de détection de la valeur de tension de la batterie (96), de sorte que les intervalles de temps pendant la première période de temps (T1) soient plus courts que les intervalles de temps pendant la seconde période de temps (T2).

5. Dispositif de contrôle de moteur (10) selon l'une quelconque des revendications 1 à 4, dans lequel
le contrôleur d'alimentation (128) établit la valeur de courant ou le facteur de marche utilisé lors du démarrage de l'entraînement dans le sens de rotation normale à une valeur qui est sensiblement la même que la valeur de courant ou le facteur de marche utilisé pendant la première période de temps(T1).

6. Dispositif de contrôle de moteur (10) selon l'une quelconque des revendications 1 à 5, dans lequel
le contrôleur (36) a un contrôleur d'arrêt au ralenti (124) configuré pour effectuer un contrôle de l'arrêt au ralenti qui arrête automatiquement le moteur (E) pendant qu'un véhicule est arrêté, et
le contrôleur (36) interdit le fonctionnement du contrôleur d'arrêt au ralenti (124) si l'unité de détermination d'état de la batterie (126) détermine que la batterie (96) est dans un état anormal.
